## Europäisches Patentamt
### European Patent Office
### Office européen des brevets

(11) Veröffentlichungsnummer: **0 316 950**

**A2**

# EUROPÄISCHE PATENTANMELDUNG

(21) Anmeldenummer: 88119241.3

(22) Anmeldetag: **18.11.88**

(51) Int. Cl.⁴: **H01L 23/48 , H01L 23/52**

Ein Antrag gemäss Regel 88 EPÜ auf Berichtigung liegt vor. Über diesen Antrag wird im Laufe des Verfahrens vor der Prüfungsabteilung eine Entscheidung getroffen werden (Richtlinien für die Prüfung im EPA, A-V, 2.2).

(30) Priorität: **18.11.87 DD 309166**

(43) Veröffentlichungstag der Anmeldung:
**24.05.89 Patentblatt 89/21**

(84) Benannte Vertragsstaaten:
**AT DE FR SE**

(71) Anmelder: **VEB ELEKTRONISCHE BAUELEMENTE TELTOW**
**Ernst-Thälmann-Strasse 10**
**DDR-1530 Teltow(DD)**

(72) Erfinder: **Hinueber, Wilfried, Dr.-Ing.**
**Adalbert-Stifter-Weg 9**
**DDR-8029 Dresden(DD)**
Erfinder: **Schumann, Joachim, Dr.**
**Vetschauer Strasse 3**
**DDR-8036 Dresden(DD)**
Erfinder: **Heinrich, Armin, Dr.**
**Kaliningrader Strasse 18**
**DDR-8057 Dresden(DD)**
Erfinder: **Müller, Bernd, Dipl.-Ing.**
**Anna-Seghers-Strasse 4-6**
**DDR-1505 Bergholz-Rehbrücke(DD)**
Erfinder: **Jarcak, Wolfgang, Dr.**
**Turnstrasse 27**
**DDR-1502 Babelsberg(DD)**
Erfinder: **Bierbrauer, Lutz, Dipl.-Ing.**
**Karl-Liebknecht-Steig 6**
**DDR-1530 Teltow(DD)**
Erfinder: **Heisig, Ullrich, Dr.**
**Elisabethstrasse 12**
**DDR-8051 Dresden(DD)**
Erfinder: **Pfannkuchen, Rolf, Dipl.-Ing.**
**Franz-Koegler-Ring 93**
**DDR-9200 Freiberg(DD)**
Erfinder: **Baether, Karl-Heinz, Dr.**
**Kerstingstrasse 39**
**DDR-8020 Dresden(DD)**

(74) Vertreter: **von Füner, Alexander, Dr. et al**
**Patentanwälte v. Füner, Ebbinghaus, Finck**
**Mariahilfplatz 2 & 3**
**D-8000 München 90(DE)**

(54) **Weichlötbare Dünnschicht in einer ein- oder mehrschichtigen Metallisierung.**

(57) Die Erfindung bezieht sich auf diskrete Dünnschicht-Bauelemente, in Dünnschichttechnik hergestellte Bauelemente in Hybridschaltkreisen, Halbleiterbauelemente, integrierte Schaltkreise und Solarzellen. Erfindungsgemäß besteht die Schicht aus einem weichlötbaren Werkstoff mit Zusatz von 4 bis 18 At.-% Chrom, Zirkonium, Titan oder Aluminium. Die Schicht enthält am Substrat maximal 20 At.-

% Sauerstoff, wobei die Sauerstoffkonzentration mit zunehmender Schichtdicke monoton abnimmt. Beim Erreichen von ca. 1/3 der Schichtdicke beträgt die Sauerstoffkonzentration Null.

## WEICHLÖTBARE DÜNNSCHICHT IN EINER EIN- ODER MEHRSCHICHTIGEN METALLISIERUNG

Die Erfindung betrifft das Gebiet der Elektronik. Objekte, bei denen ihre Anwendung möglich und zweckmäßig ist, sind diskrete Dünnschicht-Bauelemente, in Dünnschichttechnik hergestellte Bauelemente in Hybridschaltkreisen, Halbleiterbauelemente, integrierte Schaltkreise und Solarzellen.

Es ist allgemein bekannt, die funktionelle Verbindung von Bauelementen und weiteren Verbindungselementen durch Löten herzustellen. Dazu muß eine Metallisierung der Bauelemente vorgenommen werden. Sie muß zahlreiche, aus physikalisch-technischer Sicht teilweise widersprüchliche Forderungen, beispielsweise hohe thermodynamische Stabilität und gute Haftfestigkeit, minimalen Kontaktwiderstand und geringen Diffusionskoeffizienten, chemische Resistenz gegen flüssige oder gasförmige Medien und hohe Ablegierfestigkeit, erfüllen. Es ist ebenso allgemein bekannt, zur Erfüllung dieser Forderungen übereinander meist mehrere dünne Schichten als Dünnschichtsystem anzuordnen. Um die Lötbarkeit der Bauelemente auch nach längerem Lagern in oxidierender Atmosphäre, z.B. Luft, zu gewährleisten, wird als letzte Schicht meist eine Edelmetallschicht angeordnet (vergl. DE-OS 28 09 863, DE-OS 30 27 159, DE-OS 30 29 277, DE-OS 33 01 666). Das Aufbringen dieser Schichten erfolgt durch chemische oder physikalische Abscheidung aus der Gasphase, aber auch durch galvanische Abscheidung. Der Nachteil dieser Metallisierung besteht im hohen technologischen und ökonomischen Aufwand.

Bekannt ist eine Metallisierungsschicht aus einer binären Kupferlegierung mit 2 bis 12 Ma.-% Sn oder einer ternären Kupferlegierung mit 30 bis 50 Ma.-% Ni und Sn, In, Ge, Si oder Ga als weiteres Zusatzelement (DD-PS 238 883). Nachteilig ist bei dieser Schicht die mangelhafte Oxidationsfestigkeit, geringe Haftfestigkeit und hohe Ablegierneigung.

Der Erfindung liegt die Aufgabe zugrunde, eine weichlötbare Dünnschicht zu schaffen, die kein Edelmetall enthält, gut lötbar ist und Mehrfachlötungen zuverlässig ermöglicht, um den technologischen Aufwand zu senken, die Oxidationsfestigkeit und die Haftfestigkeit zu erhöhen und die Ablegierneigung zu verringern.

Erfindungsgemäß wird die Aufgabe dadurch gelöst, daß die Schicht aus einem weichlötbaren Werkstoff mit Zusatz von 4 bis 18 At.-% Chrom, Zirkonium, Titan oder Aluminium besteht. Die Schicht enthält am Substrat maximal 20 At.-% Sauerstoff, wobei die Sauerstoffkonzentration mit zunehmender Schichtdicke monoton abnimmt. Beim Erreichen von ca. 1 3 der Schichtdicke beträgt die Sauerstoffkonzentration Null.

Vorzugsweise ist der weichlötbare Werkstoff Kupfer oder Nickel.

Zweckmäßigerweise ist dem weichlötbaren Werkstoff 5 bis 12 At.-% Chrom zugesetzt.

Die Höhe des Sauerstoffgehaltes der Schicht am Substrat ist von den technologischen Wärmebehandlungsbedingungen bzw. von den Betriebstemperaturen abhängig. Temperaturen ≦ 700°C ist der maximale Sauerstoffgehalt zugeordnet. Die Vorteile der erfindungsgemäßen Lösung bestehen insbesondere darin, daß die erfindungsgemäße Schicht gut lötbar, auch in oxidischer Atmosphäre hochtemperaturwärmebehandelbar ist und eine sehr hohe Haftfestigkeit und Ablegierbeständigkeit beim Lötprozeß aufweist. Für die Metallisierung werden keine Edelmetallschichten benötigt. Die elektrische Leitfähigkeit der Schicht ist hoch. Die ökonomischen Vorteile bestehen darin, daß das für eine Metallisierung notwendige Schichtsystem auf wenige und erforderlichenfalls auf nur eine Schicht reduziert werden kann. Mit der erfindungsgemäßen weichlötbaren Dünnschicht können die Funktionskomponenten einer Haftschicht, einer Lötschicht, einer Lötstoppschicht, einer Diffusionsbarriere und einer Leitbahn vereinigt werden. Es ist möglich und günstig, die Abscheidung des Schichtsystems ohne Vakuumunterbrechung durchzuführen.

Die Erfindung wird in den nachfolgenden Ausführungsbeispielen näher erläutert.

1. Ein thermisch oxidiertes Si-Substrat, auf dem eine strukturierte CrSiWo-Widerstandsschicht aufgebracht ist, soll mit einer Kontaktmetallisierung versehen werden. Zu diesem Zweck wird auf dieser Widerstandsschicht eine erfindungsgemäße weichlötbare Dünnschicht aus Ni und 6 At.-% Cr von 500 nm Dicke, die anfangs 6 At.-% $O_2$ enthält, deren $O_2$-Gehalt in der Schicht monoton abnimmt und bei einer Dicke von 160 nm Null beträgt, und darüber eine weitere 1,3 µm dicke lötbare Schicht aus CuNiSn angeordnet. Die Schichten werden in Vakuumfolge mit DC Planar Plasmatrons aufgesputtert.

2. Auf einem Siliciumsubstrat, das mit einer CrSiWo-Widerstandsschicht versehen ist, ist eine Kontaktmetallisierung aufzubringen. Dazu wird auf dieser Widerstandsschicht eine erfindungsgemäße weichlötbare Dünnschicht aus Ni, dem 6 At.-% Cr zulegiert sind, aufgesputtert. Bei Beginn des Sputterprozesses wird ein $O_2$-Partialdruck von $8 \times 10^{-3}$ Pa eingestellt. Ist eine Schichtdicke von 50 nm erreicht, wird der $O_2$-Partialdruck monoton verringert, so daß er beim Erreichen einer Schichtdicke von 350 nm Null beträgt. Nun wird noch eine 1,2 µm dicke NiCr-Schicht ohne $O_2$ aufgesputtert. Die

Abscheidung erfolgt ohne Unterbrechung des Vakuums und des Sputterprozesses. Abschließend erfolgt eine Wärmebehandlung bei 500° C in einem elektrisch beheizten Ofen für die Dauer von 30 min an Luft. Es wird eine festhaftende Kontaktmetallisierung erreicht. Der Sauerstoffgehalt im unteren Teil der erfindungsgemäßen Schicht bewirkt eine erhebliche Herabsetzung der Diffusionsgeschwindigkeit, wogegen der Teil der Schicht mit abnehmendem $O_2$-Gehalt die Ablegierbeständigkeit der weichlötbaren Dünnschicht erhöht. Die Wärmebehandlung verbessert die Leitfähigkeit der Kontaktmetallisierung noch erheblich. Bei einer Temperung an Luft bei Temperaturen > 350° C ist vor dem Lötvorgang eine Oxidätzung mit bekannten Mitteln, z.B. 5 bis 10%-igen HF notwendig. Ein weiterer Vorteil der weichlötbaren Dünnschicht besteht darin, daß die Wärmebehandlung zur Widerstandseinstellung mit der bereits aufgebrachten Kontaktmetallisierung gemeinsam vorgenommen werden kann.

## Ansprüche

1. Weichlötbare Dünnschicht in einer ein- oder mehrschichtigen Metallisierung, **dadurch gekennzeichnet,** daß die Schicht aus einem weichlötbaren Werkstoff mit Zusatz von 4 bis 18 At.-% Chrom, Zirkonium, Titan oder Aluminium besteht, die Schicht am Substrat maximal 20 At.-% Sauerstoff enthält, die Sauerstoffkonzentration mit wachsender Schichtdicke monoton abnimmt und beim Erreichen von ca. 1/3 der Schichtdicke Null beträgt.

2. Weichlötbare Dünnschicht nach Anspruch 1, **dadurch gekennzeichnet,** daß der weichlötbare Werkstoff Kupfer oder Nickel ist.

3. Weichlötbare Dünnschicht nach Anspruch 1, **dadurch gekennzeichnet,** daß dem weichlötbaren Werkstoff 5 bis 12 At.-% Chrom zugesetzt ist.